# EUROPÄISCHE PATENTSCHRIFT

(11) **EP 1 445 868 B1**
(45) Veröffentlichungstag und Bekanntmachung des Hinweises auf die Patenterteilung: **03.05.2006**
(21) Anmeldenummer: 03360017.2
(22) Anmeldetag: 05.02.2003
(51) Int. Cl.: H03M 1/74, H03M 1/66

(54) **Verfahren zur Digital-Analog-Konvertierung und Digital-Analog-Konverter**
Method for Digital-to-Analogue conversion and Digital-to-Analogue Convertor
Procédé pour conversion numérique-analogique et convertisseur numérique analogique

(43) Veröffentlichungstag der Anmeldung: 11.08.2004
(73) Patentinhaber: ALCATEL, 75008 Paris (FR)
(72) Erfinder: Preisach, Helmut, 74354 Besigheim (DE)
(74) Vertreter: Brose, Gerhard

(56) Entgegenhaltungen:
- EP-A- 0 720 300
- GB-A- 2 176 070
- US-A- 4 746 903
- US-A- 4 791 406
- US-A1- 2002 014 984

## Beschreibung

Die Erfindung betrifft ein Verfahren zur Digital-Analog-Konvertierung nach Anspruch 1 und einen Digital-Analog-Konverter nach Anspruch 2.

Solche Digital-Analog-Konverter sind, wenn man Ein-AusSchalter als Digital-Analog-Konverter ansieht, bekannt aus EP 0 720 300 Al, US 4,791,406 und US 2002/0014984 A1.

Der erfindungsgemäße Digital-Analog-Konverter ist entstanden beim Ausgangsbeispiel der Entwicklung eines Phasenregelkreises für eine Übertragungstechnische Einheit und wird im Folgenden ausgehend von der Beschreibung dieses Phasenregelkreises erläutert. Der Phasenregelkreis, die Übertragungstechnische Einheit und die im Zusammenhang damit beschriebene Erkennungsschaltung gehören jedoch nicht selbst zur vorliegenden Erfindung.

Bei der Übertragung von Datensignalen in digitaler Form gibt es mehr oder weniger Signalverzerrungen. Immer dann, wenn eine merkbare Verzerrung zu erwarten ist, wird versucht, mit Hilfe von Signalregeneratoren das ursprüngliche Signal wiederherzustellen. Bei Digitalsignalen ist dies insofern einfacher als bei Analogsignalen, als hier nur wenige, im Fall von Binärdaten nur zwei, Signalzustände überhaupt vorkommen dürfen. Außerdem sind Übergänge zwischen zwei Signalzuständen nur zu ganz bestimmten Zeitpunkten zulässig und damit nur in der Umgebung dieser Zeitpunkte zu erwarten. Wichtig dabei ist dann, daß in der Mitte zwischen zwei Zeitpunkten die größte Wahrscheinlichkeit besteht, den korrekten Signalzustand zu finden. Der Abstand zwischen zwei solchen Zeitpunkten ist der Takt, der der Übertragung zugrunde liegt.

Will man sich ein noch nicht regeneriertes Signal auf einem Oszillographen ansehen oder einen entsprechenden Ausdruck einer Simulation betrachten, so wählt man zweckmäßiger Weise die zeitbasis (x-Achse) so, daß nach einem oder mehreren ganzen Takten das Signal (y-Achse) wieder von vorn beginnt. Die Darstellung hat dann das Aussehen eines Auges oder unmittelbar nebeneinander liegender Augen. Deshalb wird oft auch von einem "Augendiagramm", einem "Auge", der "Augenöffnung" oder dergleichen gesprochen. Diese Ausdrücke werden auch dann verwendet, wenn der kontinuierliche Signalverlauf selbst betrachtet wird.

Das Regenerieren eines solchen Signals erfolgt nun derart, daß jeweils in der Mitte des Auges, dort, wo die Augenöffnung am größten ist, der aktuelle Signalwert ermittelt wird und der nächstliegende zulässige Datenwert ausgegeben wird.

Zu diesem Zweck sind Phasenregelkreise üblich. In dem der Erfindung zugrundeliegenden Fall ergeben sich dynamische Schwankungen dadurch, daß das Eingangssignal auf Datenpakete zurückgeht, die nicht mit exakt gleichen Abständen aufeinander folgen. Langfristige Änderungen ergeben sich durch Variation der Betriebsparameter, die auch auf Alterung der betroffenen Teile zurückgehen können. Der Ausgleich der langfristigen Änderungen verursacht Phasenschwankungen, ein sogenanntes "Dithering". Dieses Dithering kann klein gehalten werden, wenn das Regelkreisfilter eine möglichst geringe obere Grenzfrequenz aufweist.

Der Vollständigkeit halber soll hier darauf hingewiesen werden, daß ein solcher Phasenregelkreis auch die Frequenz einregelt. Ein Takt, welcher so eingeregelt ist, daß an allen aufeinanderfolgenden Punkten gleicher Phase die Phase korrekt ist, hat auch die richtige Frequenz.

Im Ausgangsbeispiel kommt noch hinzu, daß der Arbeitsbereich des Phasenregelkreises sehr groß ist im Verhältnis zur mittleren Frequenz. Hier kann nicht mehr mit nur einem Oszillator gearbeitet werden; es werden vielmehr mehrere, im Ausgangsbeispiel drei, Oszillatoren bereitgestellt, von denen der jeweils geeignetste verwendet wird. Dieser muß dann in seinem ganzen Arbeitsbereich möglichst genau mit einer passenden Regelspannung angesteuert werden. Weiter muß festgestellt werden, ob der Phasenregelkreis eingerastet ist oder nicht.

Die eingangs genannten Digital-Analog-Konverter aus EP 0 720 300 A1, US 4,791,406 und US 2002/0014984 A1, bestehen aus einer Anzahl von Ein-Aus-Schaltern, deren Anzahl der von Null verschiedenen auszugebenden Werte entspricht und deren Ausgangswerte durch Summation ihrer einzelnen Ausgangsspannungen oder Ausgangsströme gebildet werden. Solche Digital-Analog-Konverter können zwar sehr schnell arbeiten, für eine sehr feinstufige Unterteilung eines großen Bereichs sind sie jedoch nicht geeignet.

Das US-Patent 4,746,903 zeigt einen Digital-Analog-Konverter, der aus zwei oder mehr Teil-Digital-Konvertern besteht, deren Eingangswerte sich aus dem zu konvertierenden Wert derart zusammensetzen, daß dessen Bits zu Gruppen von zwei oder mehr Bits aufgeteilt sind, und daß je ein Bit aus jeder Gruppe zur Bildung eines der Eingangswerte beiträgt.

Insbesondere in der Telekommunikation ist es üblich, die Konversion von digitalen Werte in analoge nicht durch statische Wandler durchzuführen, sondern eine Folge von Impulsen so zu gestalten, daß sie bei Mittelung über einen bestimmten Zeitraum einem vorgegebenen Wert entsprechen. Ein Beispiel hierzu findet sich in GB 2 176 070 A.

Der Erfindung liegt die Aufgabe zugrunde, ein Verfahren zur Digital-Analog-Konvertierung und einen Digital-Analog-Konverter mit hoher Auflösung zur Verfügung zu stellen.

Diese Aufgabe wird erfindungsgemäß gelöst durch ein Verfahren zur Digital-Analog-Konvertierung nach der Lehre des Anspruchs 1 und einen Digital-Analog-Konverter nach der Lehre des Anspruchs 2.

Der erfindungsgemäße Digital-Analog-Konverter wird durch eine Art Parallelschaltung von zwei oder mehr Teil-Digital-Analog-Konvertern mit entsprechend geringerer Auflösung realisiert. Ihre Ausgangsspannungen werden, zumindest von ihrer Wirkung her, miteinander summiert. Seine digitalen Eingangswerte werden derart aufgearbeitet (245), daß bei einem kontinuierlichen Inkrementieren oder Dekrementieren dieser Eingangswerte der Reihe nach die einzelnen Eingangswerte der zwei oder mehr Digital-Analog-Konverter (241, ..., 244) inkrementiert bzw. dekrementiert werden.

Weitere Ausgestaltungen der Erfindung sind der nachfolgenden Beschreibung zu entnehmen.

Im folgenden wird die Erfindung, ausgehend von der Beschreibung des Phasenregelkreises, unter Zuhilfenahme der beiliegenden Zeichnungen weiter erläutert:
- Figur 1: zeigt den grundsätzlichen, allgemein bekannten, Aufbau eines Phasenregelkreises.
- Figur 2: zeigt einen Ausschnitt aus dem Phasenregelkreis nach Figur 1.
- Figur 3: zeigt ein Detail des Phasenregelkreises nach Figur 2.
- Figur 4: zeigt ein weiteres Detail des Phasenregelkreises nach Figur 2.
- Figur 5: zeigt ein weiteres Detail des Phasenregelkreises nach Figur 2.
- Figur 6: zeigt weitere Ausgestaltungen des Phasenregelkreises nach Figur 2.
- Figur 7: zeigt einen Phasenregelkreis mit einer Erkennungsschaltung zum Erkennen des Eingerastet-Seins des Phasenregelkreises.
- Figur 8: zeigt einen erfindungsgemäß aufgebauten Digital-Analog-Konverter.
- Figur 9: zeigt eine praktisch besser realisierbare Version eines erfindungsgemäßen Digital-Analog-Konverters nach Figur 8.

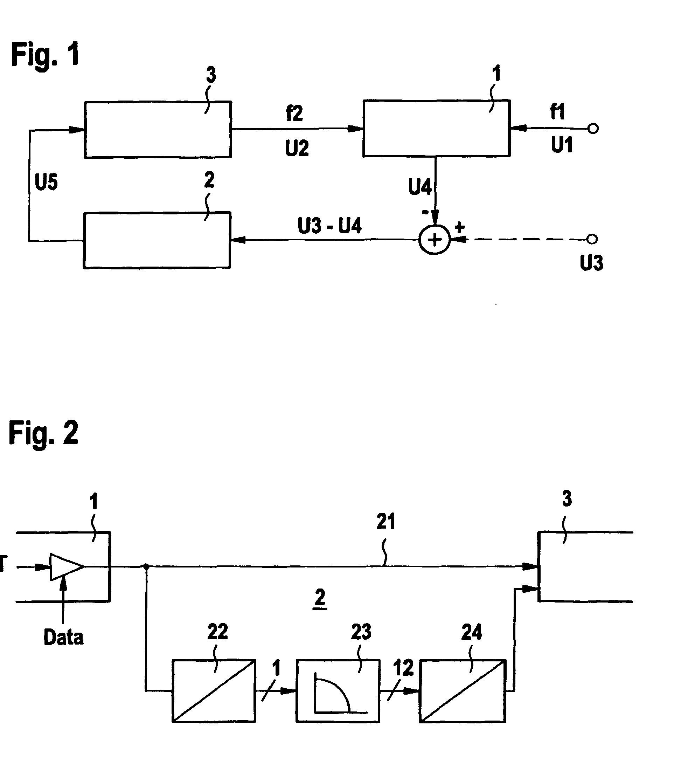

Anhand der Figur 1 wird zunächst der grundsätzliche, allgemein bekannte, Aufbau eines Phasenregelkreises beschrieben. Figur 1 basiert auf der Abbildung 27.20 des Standardwerks "Halbleiter-Schaltungstechnik" von U. Tietze und Ch. Schenk, neunte Auflage, Springer-Verlag Berlin Heidelberg New York London Paris Tokyo 1989.

Figur 1 zeigt einen Phasendetektor 1, einen Regelkreisfilter 2, dort als Regler bezeichnet, und einen spannungsgesteuerten Oszillator 3, dort als Nachlauf-Oszillator bezeichnet.

Der Phasendetektor 1 vergleicht ein Eingangssignal U1, dort als Bezugsfrequenz f1 bezeichnet, bezüglich der Phase mit dem Ausgangssignal U2 des spannungsgesteuerten Oszillators 3, dort auch mit f2 bezeichnet. Dessen Ausgangssignal U4, dort als Regelgröße bezeichnet, wird negiert und dem Eingang des Regelkreisfilters 2 zugeführt. Gegebenenfalls kann noch eine dort als Führungsgröße bezeichnete Spannung U3 zu diesem Ausgangssignal U4 addiert werden, wodurch am Eingang des Regelkreisfilters 2 eine dort als Regelabweichung bezeichnete Größe U3-U4 ansteht. Die Ausgangsspannung U5 wird dem Eingang des spannungsgesteuerten Oszillators 3 zugeführt, dort als Stellgröße bezeichnet. In dieser Darstellung weist der Phasenregelkreis keinen Ausgang auf. Als Ausgangsgröße eines Phasenregelkreises wird das Ausgangssignal U2 des spannungsgesteuerten Oszillators 3 benötigt. Insoweit hat der ganze Phasenregelkreis im Vergleich zwischen dem Takt des Eingangssignals U1 mit dem Takt des Ausgangssignals U2 einen Schwungradeffekt. Solche Phasenregelkreise werden deshalb gelegentlich als Schwungradschaltung bezeichnet.

Ein solcher Phasenregelkreis wirkt nun so, daß dann, wenn keine Spannung U3 anliegt, der spannungsgesteuerte Oszillator 3 ein Ausgangssignal U2 abgibt, dessen Frequenz f2 entweder gleich der Bezugsfrequenz f1 oder einer dazu harmonischen Frequenz (nxfl = mxf2) ist, wobei der Phasenregelkreis dann eingerastet ist, oder die Frequenz f2 einer der Bereichsgrenzen des Oszillators 3 entspricht, wobei dann der Phasenregelkreis nicht eingerastet ist. Da die Bereichsgrenzen des Oszillators 3 keine absoluten Fixpunkte sind, wird die Frequenz dann auch nicht sehr stabil sein.

Gemäß Figur 2 wird nun das Regelkreisfilter 2 in zwei parallele Zweige geteilt, wovon der erste Zweig, in der Figur der obere, im Hinblick auf die dynamischen Schwankungen ausgelegt ist, während der zweite Zweig, in der Figur der untere, im Hinblick auf die langfristigen Veränderungen dimensioniert ist. Der erste Zweig gibt hier das Ausgangssignal des Phasendetektors 1 direkt auf einen Eingang des Oszillators 3, während im zweiten Zweig ein Tiefpassfilter 23 enthalten ist.

In besonderen Fällen kann es, wie bei anderen Regelschaltungen auch, sinnvoll sein, auf schnelle Eingangsschwankungen auch schnell zu reagieren. Dies kann beispielsweise dann der Fall sein, wenn zwei längere Datenpakete in beliebigem Abstand aufeinanderfolgen. In diesem Fall kann es angebracht sein, wie auch sonst aus der Regelungstechnik bekannt, einen Differentialanteil hinzuzufügen. Dann hält der Schwungradeffekt natürlich nur bis zur nächsten sprungartigen Änderung an.

Im dargestellten Beispiel ist der erste Zweig in analoger Schaltungstechnik ausgeführt. Faktisch wirksam in diesem Zweig ist nur die Ausgangsschaltung 11 des Phasendetektors 1. Die Ausgangsschaltung 11 des Phasendetektors 1 ist hier eine Kombination aus Phasendetektor und Verstärker. Der Verstärkungsfaktor ist in dem der Erfindung zugrundeliegenden Fall zwischen 0 dB und 14 dB umschaltbar. Damit kann die Empfindlichkeit des Phasenregelkreises bezüglich der dynamischen Schwankungen eingestellt werden. Der zweite Zweig ist hier in digitaler Schaltungstechnik aufgebaut und enthält deshalb außer dem hier digital ausgeführten Tiefpassfilter 23 noch einen Analog-DigitalWandler 22 und einen Digital-Analog-Wandler 24. Die Ausgangsschaltung 11 des Phasendetektors 1 gehört formell gleichzeitig auch dem zweiten Zweig an. Der Digital-Analog-Wandler 24 hat im Beispiel einen 24-Bit-Eingang.

Die Ausgangsschaltung 11 des Phasendetektors 1 ist eine Abtast-Halte-Schaltung, die gleichzeitig auch verstärkt. Dabei wird der im Phasenregelkreis gewonnene Takt T in einer näherungsweise zu einem Sinus verformten Weise mit dem Datentakt D des ankommenden Datenstroms abgetastet. Im vorliegenden Ausgangsbeispiel, das bei etwa 10 GHz arbeitet, bedarf es keiner besonderen Maßnahmen, um den Takt sinusförmig zu verzerren. Durch Verwendung des Datentakts Data als Abtasttakt wird gleichzeitig erreicht, daß nur diejenigen Zeitpunkte in die Regelung eingehen, zu denen tatsächlich Datenflanken auftreten.

Als Takt für den digitalen Zweig wird im Ausgangsbeispiel der Systemtakt desjenigen Systems verwendet, in das der Phasenregelkreis eingebunden ist.

Im konkreten Ausgangsbeispiel ist der Phasenregelkreis Teil einer übertragungstechnischen Einheit, konkret eines Signalregenerators am Übergang zwischen elektrischen Signalen und optischen Signalen. Solche Signalregeneratoren dienen zum Wiederherstellen eines durch übertragungstechnische Störungen unbeeinflußten Signalverlaufs, letztlich also dem Rückgängigmachen der übertragungstechnischen Störungen.

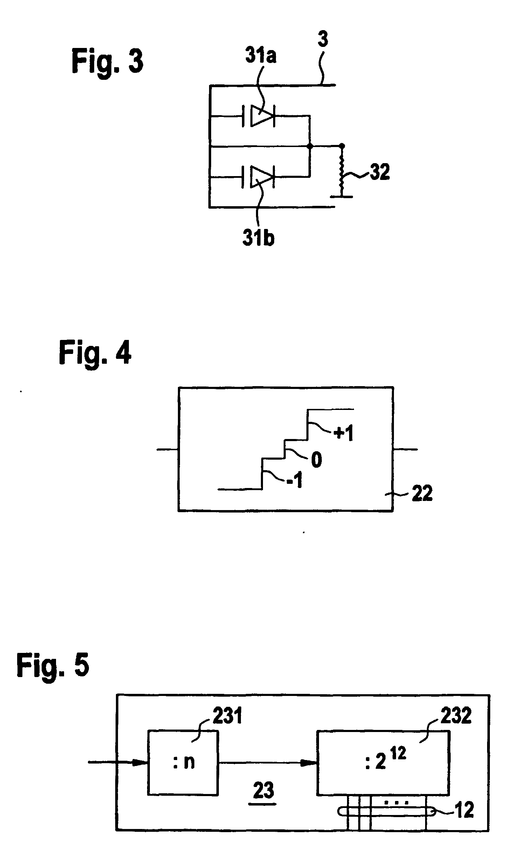

Figur 3 zeigt die frequenzbestimmenden Teile des Oszillators 3, womit gezeigt wird, wie im Beispiel die Summation der beiden Anteile der "Stellgröße" U5 erfolgt. Gezeigt sind zwei Kapazitätsdioden 31a und 31b und eine Induktivität 32.

Die beiden Kathoden der Kapazitätsdioden 31a und 31b sind je mit einer der Eingangssignale verbunden, die Anoden miteinander und mit dem einen ("heißen") Ende der Induktivität 32. Hochfrequenzmäßig liegen die beiden Kapazitätsdioden 31a und 31b zueinander und zur Induktivität 32 parallel und bilden so einen Parallelschwingkreis. Die Sperrkapazitäten der beiden in Sperrrichtung betriebenen Kapazitätsdioden 31a und 31b lassen sich durch die angelegten, als Sperrspannung wirkenden, Eingangsspannungen fein regeln.

Figur 4 zeigt die Wirkungsweise des Analog-Digital-Wandlers 22, der hier als Fensterkomparator wirkt. Der Aufbau eines Fensterkomparators bei gegebener Kennlinie ist dem Fachmann geläufig. Die Wirkungsweise ist durch die Kennlinie gegeben. Hier wird eine "0" ausgegeben, wenn die Eingangsspannung in einem schmalen Bereich um den Sollwert liegt. Liegt sie darüber, wird eine "1" ausgegeben, darunter eine "-1".

Der als einfacher Fensterkomparator ausgeführte Analog-Digital-Wandler 22 weist bereits eine Tiefpasswirkung auf, da er auch starke Veränderungen nicht stärker weitergibt als schwache.

Im weiteren wird der Tiefpass 23, wie Figur 5 zeigt, als Zähler ausgeführt. Im Beispiel ist dieser Zähler durch zwei aufeinanderfolgende Teilzähler 231 und 232 realisiert. Der erste Teilzähler 231 teilt durch einen Faktor n, während der zweite Teilzähler 232 durch einen Exponenten von 2, hier 2 hoch 12, teilt. Dessen Ausgangssignal ist eine 12-wertige Binärzahl, die dann als Eingangssignal des nachfolgenden Digital-Analog-Wandlers 24 dient. Durch den gesamten Teilerfaktor der beiden Teilzähler wird bestimmt, wie schnell und wie genau das Ausgangssignal des Fensterkomparators weitergegeben wird. Insbesondere durch den Teilerfaktor n des ersten Teilzählers 231 kann die Verzögerung und damit die obere Grenzfrequenz des Tiefpasses stark beeinflußt werden.

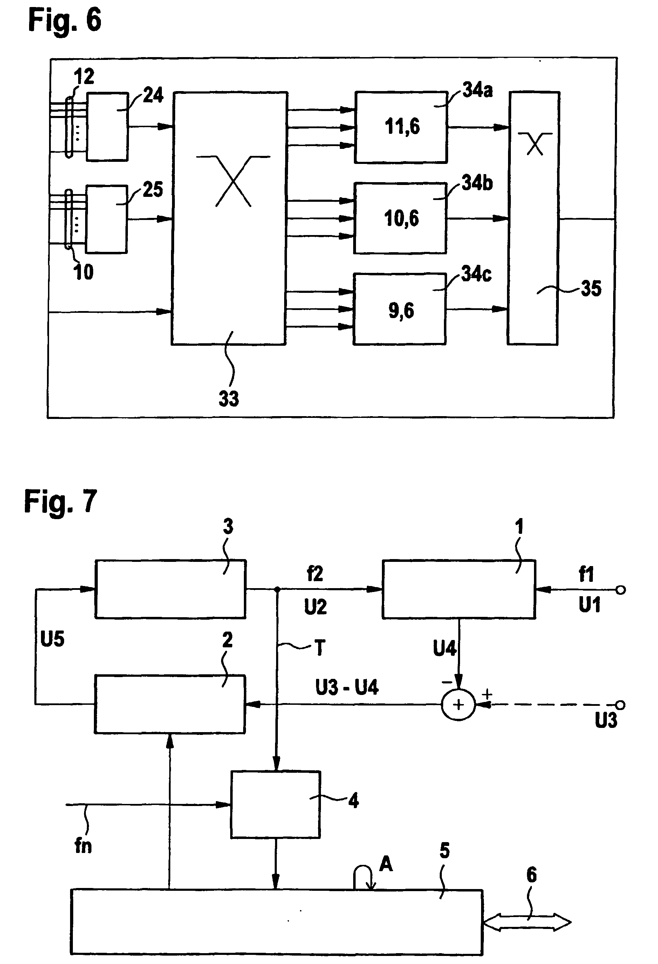

Anhand der Figur 6 wird der Aufbau des spannungsgesteuerten Oszillators 3 und sein Zusammenspiel mit dem Digital-Analog-Wandler 24 näher dargestellt.

Figur 6 zeigt den Digital-Analog-Wandler 24, einen weiteren Digital-Analog-Wandler 25, eine analoge Schaltmatrix 33, drei Oszillatoren 34a, 34b und 34c und eine weitere analoge Schaltmatrix 35.

Der Ausgang des Digital-Analog-Wandlers 24 und des weiteren Digital-Analog-Wandler 25 führen auf Eingänge der Schaltmatrix 33. Vom ersten Zweig des Regelkreisfilters 2, und damit von dessen Verstärker 21 führt ebenfalls eine Signalleitung auf einen Eingang der Schaltmatrix 33. Je drei Ausgänge der Schaltmatrix 33 führen auf Eingänge der Oszillatoren 34a, 34b und 34c. Deren Ausgänge führen auf je einen Eingang der weiteren analogen Schaltmatrix 35.

Der zugrunde liegende Oszillator soll im Bereich von 9,9 GHz bis 12,5 GHz mit jedet mit Frequenz als Arbeitsfrequenz verwendbar sein. Als Fangbereich ist ein Bereich von 8 MHz vorgesehen. Die Bandbreite des zu überstreichenden Bereichs ist im Vergleich zur Mittenfrequenz sehr groß. Deshalb sind hier drei Oszillatoren vorgesehen. Sie sind fertigungstechnisch auf Mittelfrequenzen von 9,6 GHz, 10,6 GHz und 11,6 GHz eingestellt. Durch Schwankungen in der Fertigung ergeben sich davon leicht abweichende Werte. Es ist aber sichergestellt, daß sie sich trotz der Fertigungsschwankungen um mehr als den Fangbereich überlappen.

Die drei Eingangssignale vom Eingang der Schaltmatrix 33 können nun wahlweise auf einen der drei Oszillatoren 34a, 34b und 34c analog durchgeschaltet werden. Die Schaltpunkte innerhalb der Schaltmatrix 33 sind bevorzugt sogenannte Transfergates. Der Ausgang des ausgewählten Oszillators, 34a, 34b oder 34c wird über die weitere analoge Schaltmatrix 35 zum nachfolgenden Phasendetektor analog durchgeschaltet. Auch hier kommen wieder bevorzugt Transfergates zum Einsatz. Die jeweils nicht benutzten Schaltpunkte und Oszillatoren werden abgeschaltet, um Energie zu sparen und um lokale Überhitzungen zu vermeiden. Hierzu kann in vielen Stufen einfach die jeweilige Stromquelle abgeschaltet werden.

Die schaltungstechnische Bereitstellung der genannten Schaltmatrizen und Oszillatoren kann, ebenso wie die genaue Dimensionierung im Einzelfall, seitens des Fachmanns ohne weiteres aufgrund seines Fachwissens durchgeführt werden.

Phasenregelkreise werden üblicherweise in solchen Anwendungsfällen verwendet, in denen der Arbeitsbereich klein ist im Verhältnis zur Mittenfrequenz. Dort wird dann von Anfang an geprüft, ob der Oszillator im ganzen Bereich fangen und einrasten kann. Dies ist hier nicht gegeben. Deshalb wird zunächst der Gesamtbereich wie beschrieben auf mehrere Oszillatoren, hier drei, aufgeteilt. Hier muß dann zwingend eine Auswahl getroffen werden, die auch nachprüfbar sein muß. Die Nachprüfung erfolgt nun dadurch, daß geprüft wird, ob der Phasenregelkreis eingerastet ist und nicht etwa zufällig in etwa die richtige Ausgangsfrequenz aufweist.

Die hierzu verwendete Erkennungsschaltung ist nun so aufgebaut, daß sie dem Phasenregelkreis eine Störgröße einzuprägen in der Lage ist und weiter so, daß sie eine Änderung der Ausgangsfrequenz des spannungsgesteuerten Oszillators zu erkennen in der Lage ist. Weiter ist diese Erkennungsschaltung derart aufgebaut, daß sie ein Alarmsignal abzugeben in der Lage ist, wenn ein Einprägen einer Störgröße zu einer Änderung der Ausgangsfrequenz führt.

Dem liegt die Überlegung zugrunde, daß der Phasenregelkreis die Störgröße dann ausregeln wird, wenn er eingerastet ist, andernfalls jedoch nicht.

Bevorzugt wird diese Erkennungsschaltung so aufgebaut, daß sie einen, extra hierfür oder für andere Zwecke vorgesehenen, Frequenzzähler heranziehen kann, um das Eingerastet-Sein zu erkennen.

Beispielhaft wird dies anhand der Figur 7 gezeigt. Hier wird vom bekannten Phasenregelkreis nach Figur 1 ausgegangen. Am Ausgang des Oszillators 3 ist hier ein Frequenzzähler 4 eingezeichnet, der die gemessene (gezählte) Ausgangsfrequenz des Oszillators 3 an eine Steuerschaltung 5 weiterzneldet. Der Frequenzzähler 4 benötigt hierzu eine von außen zugeführte Normalfrequenz fn. Die Steuerschaltung 5 wirkt zurück auf das Regelkreisfilter 2, um dort eine Störgröße aufprägen zu können. Die Steuerschaltung 5 ist weiter über einen Bus 6 mit der übergeordneten Anordnung, im Beispiel mit der gesamten Übertragungstechnischen Einheit, verbunden. Weiter ist in Figur 7 dargestellt, daß die Erkennungsschaltung durch die Steuerschaltung 5 ein Alarmsignal A abzugeben in der Lage ist, welches dann aber im gezeigten Beispiel in der Steuerschaltung 5 selbst wieder verarbeitet wird.

Die Rückwirkung auf das Regelkreisfilter 2 erfolgt im Beispiel dadurch, daß zum Zählerstand des Zählers 232 der digitale Wert einer Störgröße addiert oder davon subtrahiert wird. Der Wert dieser Störgröße muß so bemessen sein, daß eine daraus bei nicht eingerastetem Phasenregelkreis resultierende Frequenzänderung mit dem Frequenzmesser sicher festgestellt werden kann.

Eine andere Möglichkeit, um eine Änderung der Ausgangsfrequenz zu erkennen, könnte darin bestehen, das Aufprägen der Störgröße zeitlich zu korrelieren mit anderen Größen innerhalb des Phasenregelkreises.

Sobald im vorliegenden Ausgangsbeispiel über das Alarmsignal A festgestellt wird, daß der Phasenregelkreis nicht eingerastet ist, läuft eine Prozedur ab, die mit der Initialisierung vergleichbar ist. Auch diese Prozedur wird durch die Steuerschaltung 5 durchgeführt. Diese wird gegebenenfalls über den Bus 6 von außen unterstützt oder gibt dorthin Statusmeldungen ab.

Hier kommt der zwar schon erwähnte, aber von seiner Funktion her nicht näher erläuterte weitere Digital-Analog-Wandler 25 zum Tragen. Dieser wird mehr oder weniger statisch von der Steuerschaltung 5 angesteuert. Im Zusammenspiel mit dem Frequenzzähler 4 kann hier die ganze Schaltung durchgemessen und durchgeprüft werden. Dies kann schon bei der Fertigung, noch auf dem Wafer, erfolgen. Hier können die Kennlinien aller drei oszillatoren, 34a, 34b und 34c, durchgemessen werden. Es kann geprüft werden, ob diese Oszillatoren, 34a, 34b und 34c, einerseits insgesamt den ganzen geforderten Frequenzbereich überdekken können und ob sie sich andererseits ausreichend überlappen.

Die Kennlinien der drei Oszillatoren, 34a, 34b und 34c, können bereits hier in der Steuerschaltung 5 abgespeichert werden. Aber auch ohne Abspeicherung kann im Bedarfsfall (Initiierung oder Alarmfall) auf diese Weise schnell die für den Betrieb erforderliche Einstellung ermittelt werden. Damit kann dann auch für den Betrieb über den weiteren Digital-Analog-Wandler 25 eine Voreinstellung erfolgen. Damit kann dann eine Aufteilung der wirksamen Kapazität der frequenzbestimmenden Teile des jeweiligen Oszillators auf mehrere Kapazitätsdioden erreicht werden. Dadurch wird erreicht, daß die einzelnen Kapazitätsdioden nur in einem engen Bereich variiert werden müssen, so daß im jeweils linearsten Bereich gearbeitet werden kann.

Eine weitere Linearisierung kann erreicht werden, wenn jeweils mehrere Kapazitätsdioden parallelgeschaltet werden, die jeweils in der Mitte des linearen Teils ihrer Kennlinien betrieben werden.

Eine weitere Linearisierung kann erreicht werden, wenn jeder dieser Kapazitätsdioden ein eigener Digital-Analog-Wandler mit entsprechend geringerer Auflösung zugeordnet ist, da solche Wandler mit zunehmender Auflösung weniger linear werden.

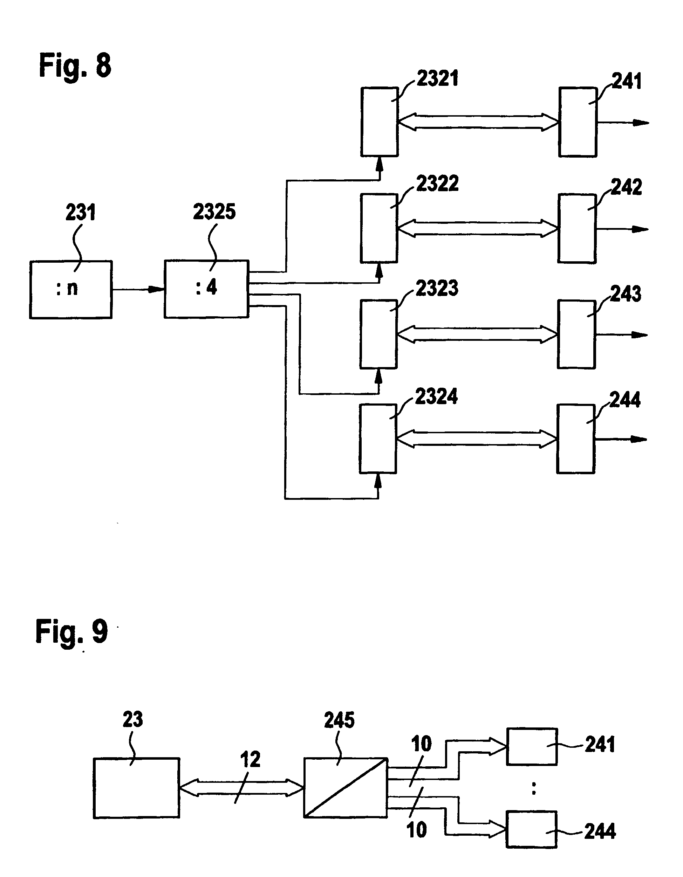

Ein Beispiel wird anhand der Figur 8 beschrieben. Dort wird der zweite Teilzähler 232 des das Tiefpassfilters 23 bildenden Zählers aufgeteilt in einen ersten Zähler 2325 bildenden Teilers durch vier mit angeschlossenem Decoder. Als Ausgangssignale ergeben sich vier abwechselnd taktende Einzelsignale. Jedem dieser Einzelsignale ist nun ein zehnstufiger Zähler 2321, 2322, 2323 bzw. 2324 zugeordnet. Jedem dieser Zähler 2321, 2322, 2323 und 2324 ist nun ein Digital-Analog-Wandler 241, 242, 243 bzw. 244 zugeordnet. Anstelle der hier dargestellten Zähltakte sind tatsächlich jeweils getrennte Signale für Dekrementieren und Inkrementieren erforderlich und auch vorgesehen. Bei kontinuierlichem Hochzählen werden die einzelnen Digital-Analog-Wandler 241, 242, 243 und 244 abwechselnd um je eine Stufe hochgefahren.

Im Ergebnis dasselbe kann natürlich auch erreicht werden, wenn, wie Figur 9 zeigt, ein Decoder 245 verwendet wird, der entsprechend der anhand der Figur 8 gezeigten Funktionalität eine 12-Bit-Zahl in vier 10-Bit-Zahlen wandelt. Dies ist im Prinzip die Funktionalität einer Tabelle, die jeder Wertekombination aus 12 Bit vier Werte mit je 10 Bit zuordnet.

## Patentansprüche

1. Verfahren zur Digital-Analog-Konvertierung eines Eingangswertes mittels eines Digital-Analog-Konverters, wobei der Digital-Analog-Konverter (24) durch zwei oder mehr Teil-Digital-Analog-Konverter (241,..., 244) realisiert ist, mit folgenden Schritten:
die analogen Ausgangsspannungen der einzelnen Teil-Digital-Analog-Konverter werden in der Wirkung zusammengefasst (Figur 3),
ihre einzelnen digitalen Eingangswerte werden derart decodiert (245), daß bei einem kontinuierlichen inkrementieren oder Dekrementieren des Eingangswertes abwechselnd der Reihe nach die einzelnen Teil-Digital-Analog-Konverter um je eine Stufe verändert werden,
wobei ihre einzelnen digitalen Eingangswerte den Ausgangswerten je eines mehrstufigen Zählers (2321 ... 2324) entsprechen.

2. Digital-Analog-Konverter (24), der durch zwei oder mehr Teil-Digital-Analog-Konverter (241, ... ,244) realisiert ist, mit einem digitalen Eingang für einen digitalen Eingangswert und pro Teil-Digital-Analog-Konverter einem analogen Ausgang zur Ausgabe einer analogen Ausgangsspannung, wobei der Digital-Analog-Konverter (24) weiter so realisiert ist, dass er in Betrieb das Verfahren nach Anspruch 1 durchführt.

## Claims

1. Method for the digital/analog conversion of an input value by means of a digital/analog converter, wherein the digital/analog converter (24) is implemented by two or more component digital/analog converters (241,..., 244), comprising the following steps:
the action of the analog output voltages of the individual component digital/analog converters are combined (Figure 3),
their individual digital input values are decoded (245) in such a way that, in the event of a continuous incrementing or decrementing of the input value, the individual component digital/analog converters are each alternately altered in turn by one step,
wherein their individual input values correspond to the output values of a multistage counter (2321 ..., 2324) in each case.

2. Digital/analog converter (24) that is implemented by two or more component digital/analog converters (241, ..., 244) having a digital input for a digital input value and one analog ouput per component digital/analog converter for outputting an analog output voltage, wherein the digital/analog converter (24) is furthermore implemented in such a way that it executes the method according to Claim 1 when in operation.

## Revendications

1. Procédé pour la conversion numérique-analogique d'une valeur d'entrée au moyen d'un convertisseur numérique-analogique, le convertisseur numérique-analogique (24) étant réalisé par deux convertisseurs numérique-analogique partiels (241, ..., 244), comprenant les étapes suivantes :
les tensions de sortie analogique des convertisseurs numérique-analogique partiels individuels sont regroupées dans l'effet (figure 3),
leurs valeurs d'entrée numériques individuelles sont décodées (245) de telle sorte que, avec une incrémentation ou une décrémentation continue de la valeur d'entrée, les convertisseurs numérique-analogique partiels individuels sont modifiés alternativement dans l'ordre à chaque fois d'un niveau,
leurs valeurs d'entrée numériques individuelles correspondant aux valeurs de sortie, de respectivement un compteur à plusieurs niveaux (2321... 2324).

2. Convertisseur numérique-analogique (24), qui est réalisé par deux convertisseurs numérique-analogique partiels (241,..., 244) ou plus, avec une entrée numérique pour une valeur d'entrée numérique et une sortie analogique par convertisseur numérique-analogique partiel pour la délivrance d'une tension de sortie analogique, le convertisseur numérique-analogique (24) étant réalisé également de telle sorte qu'il met en oeuvre le procédé selon la revendication 1 dans l'exploitation.
